# EUROPEAN PATENT APPLICATION

(11) **EP 1 648 102 A1**
(43) Date of publication of application: **19.04.2006**
(21) Application number: 04024694.4
(22) Date of filing: 15.10.2004
(51) Int. Cl.: H04H 1/00, H03J 1/00

(54) **Improved tuning algorithm for traffic information retrieval**

(71) Applicant: Leadtek Research Europe B. V., 1322 AB, Almere (NL)
(72) Inventor: Alders, Pim, 3761 CS Soest (NL); Wu, Miao-Shun, 1322 AB Almere (NL)
(74) Representative: Walter, Philipe

(57) **Abstract**

The invention relates to a method for evaluating a radio channel to be used for extracting traffic information data with searching for a valid radio channel, tuning to the valid radio channel, and extracting the traffic information from the tuned radio channel. To provide better traffic information, calculating a signal quality level from the tuned channel, calculating a traffic information data level from the number of received traffic information data within the tuned channel, and deciding whether to search for a new radio channel based on a comparison between the signal quality level and the traffic information data level and a threshold value, respectively is provided.

## Description

The invention relates in general to a method and a device for evaluating the quality of a radio channel to be used for extracting traffic information data with searching for a valid radio channel, tuning to the valid radio channel, and extracting the traffic information from the tuned radio channel.

Nowadays, mobile navigation systems often not only use position information for navigation, but additionally traffic information to calculate alternative navigation routes. For instance, the position information can be retrieved from a global positioning system (GPS) receiver. Other positioning information can also be used, for instance cell tracking in cellular mobile communication networks, triangulation of radio signals, or other satellite based or terrestrial based positioning systems.

To obtain traffic information, the European Broadcasting Union (EBU) introduced a Traffic Message Channel (TMC) protocol, comprising current traffic information coded as digital signal stream. This TMC data is provided within common broadcast radio channels. In particular Radio Digital System (RDS) receivers allow receiving the TMC data. A TMC receiver needs to find radio channels which comprise a valid RDS stream. Within this RDS stream it needs to detect the embedded TMC data. For optimal use, radio channels which provide the best TMC reception need to be found as fast as possible.

Common TMC receivers can be used in a mobile situation for obtaining the TMC data packages. However, environmental caused distortions in the radio signal may also cause errors in the received TMC data packages. The distortions can be caused, for instance, due to reflections, interferences, shading of signals, changes of channel frequencies, blocking of frequencies and others.

However, in mobile applications, in particular when used in a vehicle, it is necessary to obtain the best possible data stream of TMC data packets for fast and adaptive calculation of a navigation route. Therefore, it is an object of the invention to determine the radio channel which provides the best possible TMC data. It is another object of the invention to provide a TMC data stream with as few flaws as possible. Another object of the invention is to allow determining a radio channel, which allows receiving TMC data packages continuously. Another object of the invention is to switch between separate channels at the best possible moment in a moving vehicle to minimize the "in between signals" gap.

These and other objects of the invention are solved by a method for evaluating a radio channel to be used for extracting traffic information data with searching for a valid radio channel, tuning to the valid radio channel, and extracting the traffic information from the tuned radio channel, which is characterized by calculating a signal quality level from the tuned channel, calculating a traffic information data level from the number of received traffic information data within the tuned channel, and deciding whether to search for a new radio channel based on a comparison between the signal quality level and the traffic information data level and a threshold value, respectively.

This smart tuning method is unique since it allows using multiple sources of information to determine if a radio channel is suitable for receiving the required TMC data. In contrast to traditional tuning algorithms which only use one single source, such as FM signal strength, the inventive method utilizes at least two different sources of information, which do not necessarily rely on the signal strength indication provided by the radio tuner.

The inventive method uses several sources of information to calculate a valid value for this channel. In case one valid value drops below a certain threshold value it can be decided to look for the next channel.

A radio channel can be understood as any frequency band capable of transmitting data. In particular a radio channel can be understood as frequency band broadcasting a radio programme. Traffic information data can be understood as Traffic Message Channel (TMC) data, as standardized by the European Broadcasting Union, however, any other transmission protocol for transmitting traffic relevant data is possible. Signal quality can be understood as signal to noise ratio (SNR) within the received radio channel or any other suitable value to express the quality of a radio signal within the radio channel the tuner is tuned to. The signal quality level can be, for instance, determined from statistics about the number of received packages, the number of valid packages and/or the amount of error corrections. The traffic information data level can be understood as the quality of the received traffic information data packages, e.g. the percentage of dropped data packets, the overall received packages within a time slot, the error correction within each packet, the sensitivity level of the tuner needed to get the signal, the number of RDS resynchronizations over a period of time, or any other suitable value. The threshold value can be any value suitable to determine whether a calculated level is good enough to be used or not.

The inventive method provides increasing the signal quality level or the traffic information data level for radio channels which provide good results as long as the tuner can tune to the chosen radio channel and as long as traffic information in available within the channel. Once the tuner cannot tune to the channel or the channel does not provide sufficient traffic information, the respective level can be decreased. However, a good channel caused the level to be increased to a high value over time, thus this channel is tested several times to receive the required data until the level is decreased to the threshold value and thus causes the method to search for a new radio frequency.

The tuning according to the inventive method does not need to have all information sources to function. This method can run alongside the official TMC tuning strategy to be implemented in the end user applications as described in the standard ISO_FDIS_14819-1.

According to embodiments, calculating a digital radio signal reception level from the tuned channel and deciding whether to search for a new radio channel also based on a comparison between the digital radio signal reception level and a threshold value is provided. The digital signal reception level can be any level describing the quality of the digital radio signal, for instance, the digital radio system (RDS) signal.

Further embodiments provide calculating a signal strength level from the tuned channel and deciding whether to search for a new radio channel also based on a comparison between the signal strength level and a threshold value. The signal strength level can be provided from the radio tuner.

Waiting until a tuner has tuned to the radio channel to be evaluated before calculating at least the signal quality level and/or the traffic information data level, and/or digital radio signal reception level and/or the signal strength level is provided according to embodiments. After a radio frequency has been chosen, the tuner within the receiver takes some time to tune to this radio channel. This can be due to phase locking in the phase locked loop of the receiver or due to other tuning specific reasons. However, it is preferred that the tuner is given time until the radio channel has been tuned to, to determine the respective levels.

Calculating the signal quality level for the tuned channel from the previously calculated signal quality level altered with a factor depending at least on a signal quality value of the channel received from the tuner in case a signal is received from the tuned channel is provided according to embodiments. In case the tuner is tuned to the channel and a valid radio signal is received for this channel, the signal quality level is increased. Thus, every time when it is checked whether the channel is received correctly, the signal quality level is increased in the affirmative. Insofar, the signal quality level for the tuned radio channel will become higher the longer the channel is tuned to, causing that the threshold value is reached later when the level is decreased due to a bad channel reception.

To account for bad channel reception embodiments provide reducing the signal quality level for the tuned channel in case no signal or a bad signal is received from the tuned channel.

Embodiments also provide calculating the traffic information data level for the tuned channel from the previously calculated traffic information data level altered with a factor depending at least on a signal quality value of the channel received from the tuner in case a traffic information data packet is received from the tuned channel.

In addition, embodiments provide reducing the traffic information data level for the tuned channel in case no or bad traffic information data packets are received from the tuned channel.

These embodiments allow increasing the traffic information data level as long as good traffic information data is received and decreasing the level when the data is bad. The longer good results are received, the higher the level gets and the longer it will last until the threshold value is reached to search for a new channel.

Embodiments also provide calculating the digital radio signal reception level for the tuned channel from the previously calculated digital radio signal reception level altered with a factor depending at least on a signal quality value of the channel received from the tuner in case a digital radio signal data packet is received from the tuned channel.

Reducing the digital radio signal reception level for the tuned channel in case no or bad digital radio signal data packets are received from the tuned channel is also provided according to embodiments.

These embodiments allow increasing the digital radio signal reception level as long as good digital radio data is received and decreasing the level when the data is bad. The longer good results are received, the higher the level gets and the longer it will last until the threshold value is reached to search for a new channel.

Calculating the signal strength level for the tuned channel from the previously calculated signal strength level altered with a factor depending at least on a signal quality value of the channel received from the tuner in case a signal strength value is received from the tuned channel is also provided according to embodiments.

Further embodiments allow reducing the signal strength level for the tuned channel in case no signal strength signal is received from the tuned channel.

These embodiments allow increasing the signal strength level as long as the received signal is good and decreasing the level when the received signal is bad. The longer good results are received, the higher the level will get and the longer it will last until the threshold value is reached to search for a new channel.

To account for increasing the levels by an acceptable amount and to adjust the increase in the level each time a good signal is received, adjusting the alternation factor for the signal quality level and/or the traffic information data level, and/or digital radio signal reception level and/or the signal strength level with a correction value is provided according to embodiments.

To allow accounting for different priorities of the different levels, embodiments propose to provide different threshold values for the signal quality level, the digital radio signal reception level and/or the traffic information data level.

As a new channel needs to be searched when the current channel provides bad reception results for a certain time, embodiments provide searching for a new radio channel if at least one of the signal quality level, the digital radio signal reception level, the traffic information data and/or the signal strength level drops below the threshold value.

Another aspect of the invention is a device for receiving radio channels and arranged for evaluating a radio channel to be used for extracting traffic information data with a tuner arranged to search for a valid radio channel, and tune to the valid radio channel, and a traffic information extraction means arranged to extract the traffic information from the tuned radio channel, characterized by a first calculation means arranged to calculate a signal quality level from the tuned channel, a second calculation means arranged to calculate a traffic information data level from the number of received traffic information data within the tuned channel, and decision means arranged to decide whether to search for a new radio channel based on a comparison between the signal quality level and the traffic information data level and a threshold value, respectively.

The method can be structurally implemented within the device providing respective calculation means and determination means.

These and other aspects of the invention will be described in more detail within the following figures. In the figures show:
- FIG. 1: a flowchart of an inventive method;
- FIG. 2: a block diagram of an inventive device.

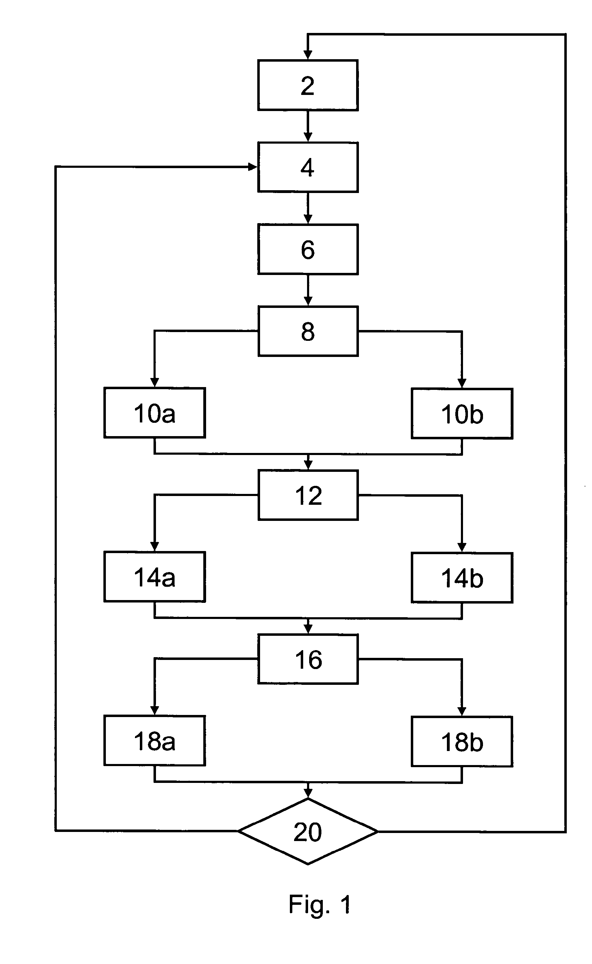

Figure 1 depicts a flowchart of an inventive method. In a first step, a tuner is requested for searching a valid tuning frequency (2) by calling
*searchnextchannel(frequencieS++).*

For instance, all available frequencies are available as *frequencies,* and these frequencies are scanned one after another until a valid frequency has been found for radio reception.

Then, it is waited until the tuner has tuned to the selected frequency (4) by calling
*while(tunerread(&frequence)==0).*

The selected frequency is provided to the tuner and the tuner returns not zero once the frequency has been tuned to. This step is processed until the selected frequency has been tuned to. In case The frequency cannot be tuned to, it can be possible to have an exit counter, which allows exiting the loop and chosen a new frequency in step (2) (not depicted).

In the next step (6) it is checked whether the tuned frequency is a valid frequency by
*if (frequence!=0)frequenceS=frequence.*

After the tuning frequency has been tuned (4) to, and the frequency is valid (6), the quality of the signal is checked. For that reason it is checked whether the tuner is still tuned to the respective frequency (8).

In case the tuner is tuned to the frequency, e.g. the channel provides a valid radio signal, the signal quality level (tunecounter) is increased (10a) with a weighted signal quality value *(signalQ)* added to the previously calculated signal quality level. The weighting can be with any factor *(tuncor).* This is implemented by
*if (tuned) tunecounter=tunecounter+2*^{***}*signalQ*^{***}*tuncor.* If the selected frequency does not deliver a valid radio channel, the signal quality level is decreased (10b) by
*else tunecounter--;*

These steps (10a, 10b) allow increasing the signal quality level as long as the selected frequency delivers a valid radio channel. Insofar, the longer the selected frequency delivers a valid channel, the higher the signal quality level gets.

It is checked whether a valid RDS signal is received (12). In case the a valid RDS signal is received within the tuner, e.g. the channel provides RDS signals with little or no error, the digital radio reception level *(rdscounter)* is increased (14a) with a weighted signal quality value *(signalQ)* added to the previously calculated digital radio reception level. The weighting can be with any factor *(errorcor).* This is implemented by
if (rds) *rdscounter=rdscounter+2*signalQ*Errorcor* If the selected channel does not deliver valid RDS signals, the digital radio reception level is decreased (14b) by
*else rdscounter* --;

These steps (14a, 14b) allow increasing the digital radio reception level as long as the selected frequency delivers a valid RDS signal. Insofar, the longer the selected frequency delivers a valid RDS signal, the higher the digital radio reception level gets.

It is checked whether within the RDS signal a valid TMC data stream is received (16). In case the a valid TMC data stream is received within the tuner, e.g. the channel provides TMC data with little or no error, the traffic information data level *(tmccounter)* is increased (18a) with a weighted signal quality value *(signalQ)* added to the previously calculated traffic information data level. The weighting can be with any factor *(errorcor).* This is implemented by
*if (rds==tmc)*
*tmccounter=tmccounter+2*SignalQ*Errorcor;*

If the selected channel does not deliver valid TMC data, the traffic information data level is decreased (18b) by
*else tmccounter* --;

These steps (18a, 18b) allow increasing the traffic information data level as long as the selected frequency delivers a valid TMC data stream. Insofar, the longer the selected frequency delivers a valid TMC data stream, the higher the traffic information data level gets.

After the signal quality level, the digital radio signal level and the traffic information data level have been calculated, the respective levels are compared with threshold values (20) by
*while((tunecounter<10)&&(rdscounter<1)&&*
*(tmccounter<2448));*

As long as the levels are higher than the threshold values, the selected frequency is not changed and the calculation of the levels is performed within steps 4 to 18 for the respective frequency. Once one level is below a threshold value, a new frequency is selected in step 2 and the levels are recalculated with the new frequency. In this step 2, the levels can be, for instance, initialized for each new frequency to the threshold values or a value slightly above the threshold value.

### The pseudo code of such a method can be:

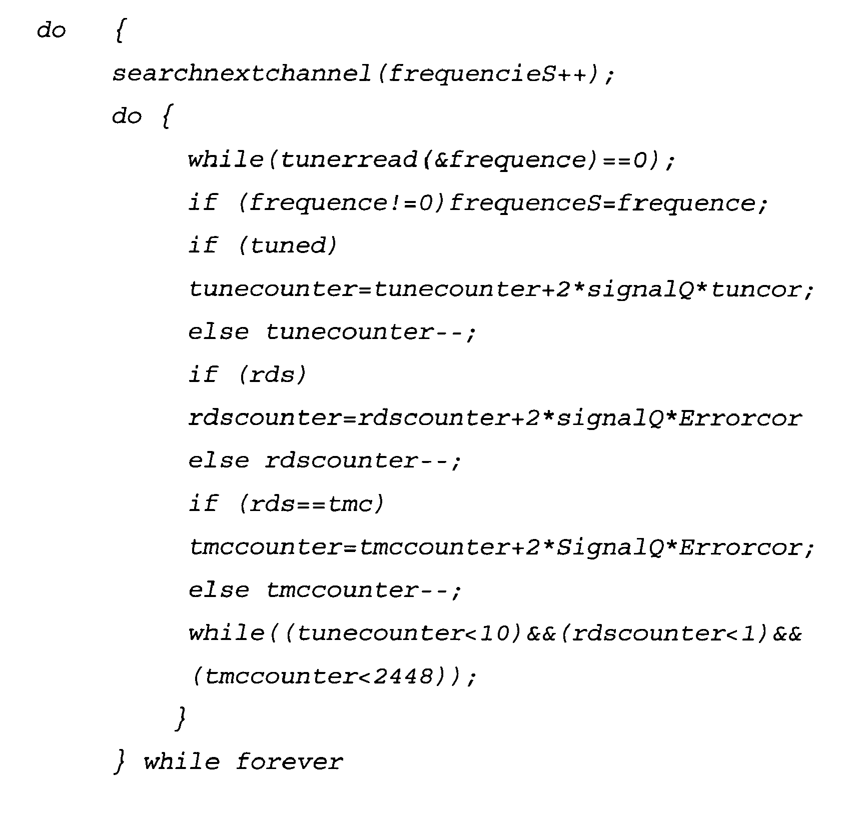

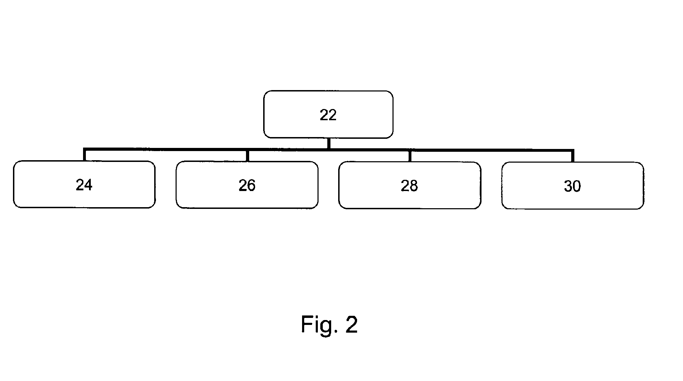

Figure 2 illustrates a block diagram of an inventive device. The device comprises a tuner manager 22, an RDS quality measuring device 24, a tuning quality device 26, an RDS statistics measuring device 28, and a TMC quality measuring device 30.

Once a frequency has been tuned to, the tuner manager 22requests from the devices 24-30 the respective levels.

The RDS quality measuring device 24 and the RDS statistics measuring device 28 calculate the digital radio signal quality level for instance based on the number of dropped packages, the number of error corrections or any other suitable value.

The tuning quality device 26 calculates the signal quality level for instance based on the number of retunes required or any other suitable value.

The TMC quality measuring device 30 calculates the traffic information data level, for instance, based on the number TMC data packages received, the number of dropped TMC packages, or any other suitable value

Using the at least two sources for evaluating the quality of a radio channel for receiving traffic information increases the quality of the received navigational data. The frequency which provides best results can be found fast. A frequency which delivered good results is tried more often to receive the traffic information than a frequency which provided poor results from the start.

## Claims

1. Method for evaluating a radio channel to be used for extracting traffic information data with
- searching for a valid radio channel,
- tuning to the valid radio channel, and
- extracting the traffic information from the tuned radio channel,
**characterized by**
- calculating a signal quality level from the tuned channel,
- calculating a traffic information data level from the number of received traffic information data within the tuned channel, and
- deciding whether to search for a new radio channel based on a comparison between the signal quality level and the traffic information data level and a threshold value, respectively.

2. The method of claim 1, with calculating a digital radio signal reception level from the tuned channel and deciding whether to search for a new radio channel also based on a comparison between the digital radio signal reception level and a threshold value.

3. The method of claim 1 or 2, with calculating a signal strength level from the tuned channel and deciding whether to search for a new radio channel also based on a comparison between the signal strength level and a threshold value.

4. The method of any one of claims 1 to 3 , with waiting until a tuner has tuned to the radio channel to be evaluated before calculating at least the signal quality level and/or the traffic information data level, and/or digital radio signal reception level and/or the signal strength level.

5. The method of any one of claims 1 to 4, with calculating the signal quality level for the tuned channel from the previously calculated signal quality level altered with a factor depending at least on a signal quality value of the channel received from the tuner in case a signal is received from the tuned channel.

6. The method of any one of claims 1 to 5, with reducing the signal quality level for the tuned channel in case no signal is received from the tuned channel.

7. The method of any one of claims 1 to 6, with calculating the traffic information data level for the tuned channel from the previously calculated traffic information data level altered with a factor depending at least on a signal quality value of the channel received from the tuner in case a traffic information data packet is received from the tuned channel.

8. The method of any one of claims 1 to 7, with reducing the traffic information data level for the tuned channel in case no traffic information data packet is received from the tuned channel.

9. The method of any one of claims 1 to 8, with calculating the digital radio signal reception level for the tuned channel from the previously calculated digital radio signal reception level altered with a factor depending at least on a signal quality value of the channel received from the tuner in case a digital radio signal data packet is received from the tuned channel.

10. The method of any one of claims 1 to 9, with reducing the digital radio signal reception level for the tuned channel in case no digital radio signal data packet is received from the tuned channel.

11. The method of any one of claims 1 to 10, with calculating the signal strength level for the tuned channel from the previously calculated signal strength level altered with a factor depending at least on a signal quality value of the channel received from the tuner in case a signal strength value is received from the tuned channel.

12. The method of any one of claims 1 to 11, with reducing the signal strength level for the tuned channel in case no signal strength signal is received from the tuned channel.

13. The method of any one of claims 1 to 12, with adjusting the alternation factor for the signal quality level and/or the traffic information data level, and/or digital radio signal reception level and/or the signal strength level with a correction value.

14. The method of any one of claims 1 to 13, with providing different threshold values for the signal quality level, the digital radio signal reception level and/or the traffic information data level.

15. The method of any one of claims 1 to 14, with searching for a new radio channel if at least one of the signal quality level, the digital radio signal reception level, the traffic information data and/or the signal strength level drops below the threshold value.

16. Device for receiving radio channels and arranged for evaluating a radio channel to be used for extracting traffic information data with
- a tuner arranged to search for a valid radio channel, and tune to the valid radio channel, and
- a traffic information extraction means arranged to extract the traffic information from the tuned radio channel,
**characterized by**
- a first calculation means arranged to calculate a signal quality level from the tuned channel,
- a second calculation means arranged to calculate a traffic information data level from the number of received traffic information data within the tuned channel, and
- decision means arranged to decide whether to search for a new radio channel based on a comparison between the signal quality level and the traffic information data level and a threshold value, respectively.
